# DEMANDE DE BREVET EUROPEEN

(11) **EP 0 639 876 A1**
(43) Date de publication de la demande: **22.02.1995**
(21) Numéro de dépôt: 94401865.4
(22) Date de dépôt: 17.08.1994
(51) Int. Cl.: H01S 3/25

(54) **Amplificateur optique à semi-conducteur, présentant une non-linéarité réduite**

(30) Priorité: 20.08.1993 FR 9310147
(71) Demandeur: ALCATEL N.V., NL-1077 XX Amsterdam (NL)
(72) Inventeur: Doussiere, Pierre, F-91180 Saint Germain les Arpajons (FR); Simon, Jean-Claude, F-22700 Louannec (FR); Valiente, Ivan, F-22300 Caouennec Lanvezeac (FR); Brosson, Philippe, F-91470 Forges les Bains (FR)
(74) Mandataire: Fournier, Michel

(57) **Abrégé**

Le gain de l'amplificateur est stabilisé en faisant osciller ce dernier à une longueur d'onde non utilisée pour l'amplification du signal d'entrée (Pi). Un exemple de réalisation comporte :
- un substrat (2)
- un guide optique actif (3);
- un réseau (4) couplé tout le long du guide optique (3), et ayant une longueur d'onde de Bragg différente de la longueur d'onde du signal à amplifier;
- deux électrodes (1,6) pour injecter transversalement un courant électrique (I).

Application aux systèmes de transmission de signaux optiques.

## Description

L'invention concerne un amplificateur optique à semiconducteur, présentant une non-linéarité réduite. Un tel amplificateur peut être utilisé dans le domaine des télécommunications par fibre optique, notamment pour amplifier un signal optique avant de le transmettre à grande distance. Actuellement deux types d'amplificateur optique sont utilisés pour cette application : l'amplificateur à semiconducteur, et l'amplificateur à fibre dopée par une terre rare.

Pour la transmission autour d'une longueur d'onde de 1,55 micron, l'amplificateur à fibre dopée à l'erbium est le plus couramment utilisé, essentiellement parce qu'il ne présente pas de non-linéarité de gain en fonction de la puissance du signal d'entrée pour les signaux utilisés dans les systèmes de télécommunication optique. Le temps de récupération du gain dans un amplificateur à fibre dopée à l'erbium est supérieur à 0,1 ms. Ce temps de récupération élevé procure une stabilisation du gain parce que celui-ci n'a pas le temps de remonter lorsque le signal passe d'un état haut à un état bas, pour les fréquences de modulation utilisées dans le domaine des télécommunications, qui sont de l'ordre de 100 MHz à 10 GHz.

Par contre, à cause d'un temps de récupération très court, les amplificateurs à semiconducteur présentent une importante non-linéarité de gain jusqu'à des fréquences de modulation de plusieurs gigahertz, lorsque l'amplificateur travaille en régime de saturation. Classiquement, un amplificateur optique à semiconducteur comporte un guide optique actif dans lequel un courant électrique est injecté transversalement. Le signal d'entrée, à amplifier, est injecté à une extrémité du guide, et le signal optique amplifié est recueilli à l'autre extrémité du guide. Le gain d'un amplificateur classique à semiconducteur est, en première approximation, une fonction linéaire de la densité de porteurs de charge électrique dans le guide actif. Cette densité de porteurs résulte d'un équilibre entre le taux de pompage par l'injection de courant électrique, qui tend à augmenter cette densité, et le taux de recombinaison par émission stimulée dû à l'amplification du signal, qui tend à diminuer cette densité. Toute modification du taux de pompage, ou de la puissance du signal d'entrée, modifie la densité de porteurs et donc modifie le gain de l'amplificateur. En particulier, lorsque la puissance du signal d'entrée augmente, le taux de recombinaison des porteurs augmente sous l'effet de l'augmentation du nombre de photons et de l'émission stimulée, par conséquent la densité de porteurs décroît et le gain baisse. Inversement, lorsque la puissance du signal d'entrée diminue, le taux de recombinaison diminue sous l'effet de la baisse du nombre de photons, par conséquent la densité de porteurs croît, et le gain augmente.

Cette augmentation du gain est très rapide. Après une coupure instantanée du signal d'entrée, le temps de récupération du gain est inférieur à 500 picosecondes. Le gain varie donc en fonction des données binaires modulant le signal amplifié, malgré la fréquence de modulation très élevée généralement utilisée dans le domaine des télécommunications. Cette non-linéarité provoque une réduction de contraste entre le niveau haut et le niveau bas du signal amplifié, donc une réduction du taux de modulation du signal, et donc une réduction du rapport signal sur bruit. De plus, dans le cas où plusieurs canaux multiplexés spectralement sont amplifiés simultanément les fluctuations du gain dues à cette non-linéarité engendrent une diaphonie entre les différents canaux. L'utilisation des amplificateurs à semiconducteur est donc limitée au cas des petits signaux, pour éviter cette perte de contraste, et cette diaphonie.

Par ailleurs, les signaux analogiques du type MABLR (modulation analogique à bande latérale réduite) utilisés pour la distribution de vidéo sur fibre optique ne peuvent pas à l'heure actuelle être amplifiés dans un amplificateur semiconducteur du fait des très faibles niveaux de distorsion requis.

Des solutions ont été proposées dans le but de remédier au comportement non linéaire d'un amplificateur à semiconducteur:
- L'utilisation d'une contre-réaction électrique agissant sur l'intensité du courant électrique injecté dans l'amplificateur, en fonction de l'amplitude du signal amplifié sortant de cet amplificateur. Cette solution est peu efficace dès que la fréquence de modulation dépasse quelques centaines de mégaherz et requiert un circuit électronique dont l'encombrement, la consommation électrique, et le coût dépassent largement ceux de l'amplificateur lui-même.
- L'utilisation de matériaux semiconducteurs à puits quantiques. Cette solution permet d'augmenter la puissance du signal pour laquelle le phénomène de non-linéarité apparaît. Les valeurs mentionnées dans la littérature font état d'une augmentation de 5 dB de la puissance disponible à la sortie de l'amplificateur. Toutefois, cette solution ne fait que repousser le seuil d'apparition de la non-linéarité, mais ne supprime pas celle-ci, et ne permet donc pas d'exploiter toute la puissance théoriquement disponible pour le signal amplifié, qui requiert typiquement une compression de 4 dB du gain.

La demande de brevet japonais JP-A-01 143 382 décrit un amplificateur optique à semi-conducteur comportant un laser à semi-conducteur, ce dernier émettant sur une première longueur d'onde. Le signal optique à amplifier a une seconde longueur d'onde, différente de la première. Il est injecté dans la couche active du laser à travers un isolateur optique. Un filtre de sortie ne laisse passer que la seconde longueur d'onde, afin d'extraire le signal amplifié. Le laser comporte deux faces clivées situées respectivement aux deux extrémités de la couche active. Elles ne sont pas traitées anti-reflet et forment donc une cavité qui résonne sur de nombreuses longueurs d'onde. L'oscillation laser maintient constante la densité d'électrons et de trous quand l'intensité du signal à amplifier varie. Le gain est donc stabilisé mais cette amplification n'est pas satisfaisante parce qu'elle est résonnante sur les pics de résonance de la cavité, le signal à amplifier se réfléchissant partiellement sur les faces clivées et créant des ondes stationnaires dans la cavité. Le signal à amplifier doit avoir une longueur d'onde correspondant à l'un des pics de résonance de la cavité. Cette condition est difficile à satisfaire en pratique, car les longueurs des pics de résonance varient en fonction de plusieurs paramètres difficiles à maîtriser. Toute dérive des pics provoque donc une chute du gain de l'amplificateur.

Le but de l'invention est de proposer un amplificateur optique à semiconducteur dans lequel le gain soit constant jusqu'à des fréquences de modulation très élevées, sans nécessiter un dispositif extérieur à cet amplificateur; permettant d'exploiter toute la puissance théoriquement disponible pour le signal amplifié; et où l'amplification soit à onde progressive et non pas à onde stationnaire.

L'objet de l'invention est un amplificateur optique à semiconducteur, présentant une non-linéarité réduite, caractérisé en ce qu'il comporte un guide optique et des moyens résonants couplés à ce guide pour faire osciller cet amplificateur à une longueur d'onde unique différente de la longueur d'onde d'un signal à amplifier, mais appartenant à la bande de gain de l'amplificateur, et pour assurer une amplification à onde progressive du signal à amplifier.

L'amplificateur ainsi caractérisé présente, pour toute longueur d'onde différente de la longueur d'onde d'oscillation, un gain en onde progressive constant par rapport aux variations du signal amplifié, grâce à un phénomène analogue à un phénomène déjà connu dans les lasers à semiconducteurs.

En effet, le gain d'un laser à semi-conducteur est bloqué à une valeur fixe, égale à l'inverse des pertes de la cavité, dès qu'il a atteint le seuil d'oscillation. Au-delà du seuil, l'oscillation vide l'excès de porteurs injectés, et maintient la densité de porteurs à une valeur d'équilibre correspondant au gain minimal nécessaire pour entretenir l'oscillation. Toute injection de porteurs supplémentaires, produite par l'augmentation du courant électrique injecté, provoque une augmentation de la puissance émise à la longueur d'onde de l'oscillation sans augmentation de la densité de porteurs à l'équilibre. Inversement, toute diminution du courant électrique se traduit par une diminution de la puissance émise à la longueur d'onde d'oscillation, sans modifier la densité de porteurs à l'équilibre.

Dans l'amplificateur selon l'invention, le gain de l'amplificateur est stabilisé en le faisant osciller, comme un laser, à une longueur d'onde non utilisée pour l'amplification du signal d'entrée. Cependant l'amplification est à onde progressive, car les moyens résonants utilisés ne résonnent qu'à une seule longueur d'onde. En pratique, le résonateur utilisé peut être un résonateur résonnant sur deux longueurs d'onde très proches. Dans l'hypothèse où la raie de fluorescence du matériau constituant le guide présente un élargissement globalement homogène, ce qui est le cas pour les semiconducteurs, toute l'étendue spectrale de la courbe de gain de l'amplificateur est stabilisée par l'oscillation laser bien que celle-ci n'existe qu'à une longueur d'onde déterminée, située à l'intérieur de cette étendue spectrale. Grâce à cette stabilisation du gain, l'amplificateur selon l'invention ne présente pas les effets gênants d'une non-linéarité : diminution du contraste; et diaphonie dans le cas de canaux multiplexés spectralement.

Selon un mode de réalisation préférentiel, les moyens résonants comportent au moins un réseau distribué, chaque réseau étant couplé au guide optique et ayant une longueur d'onde de Bragg égale à la longueur d'onde choisie pour l'oscillation.

L'invention sera mieux comprise et d'autres caractéristiques apparaîtront à l'aide de la description ci-dessous d'exemples de réalisation :
- la figure 1 représente la répartition spectrale de la raie d'oscillation , de la raie du signal amplifié, et de l'émission spontanée amplifiée, dans un amplificateur selon l'invention;
- la figure 2 représente le schéma synoptique d'un premier exemple de réalisation d'un amplificateur selon l'invention, vu en coupe longitudinale;
- la figure 3 représente une coupe transversale de ce premier exemple de réalisation;
- la figure 4 représente une coupe transversale d'une variante de ce premier exemple de réalisation;
- la figure 5 représente un graphe du gain en fonction de la puissance du signal amplifié, d'une part pour un amplificateur classique, et d'autre part pour un amplificateur selon l'invention;
- les figures 6 et 7 représentent deux autres exemples de réalisation de l'amplificateur selon l'invention.

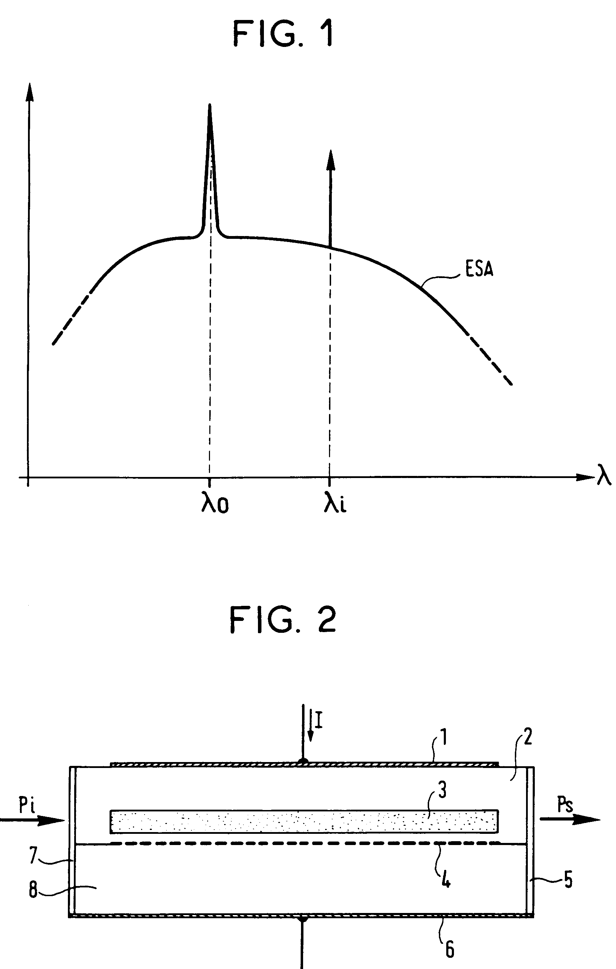

Le diagramme représenté sur la figure 1 représente la répartition spectrale de la raie d'oscillation λo, de la raie λi du signal amplifié, et l'émission spontanée amplifiée ESA qui est répartie dans toute la bande de gain d'un amplificateur selon l'invention. La longueur d'onde λi peut être supérieure ou inférieure à la longueur d'onde λ_{O} mais elle doit être différente de λₒ, pour permettre de séparer, par filtrage, le signal amplifié du signal produit par l'oscillation.

Par ailleurs, cette séparation doit être suffisamment grande pour éviter la création de bandes latérales parasites par mélange à quatre ondes.

La puissance de la raie λ_{O} de l'oscillation décroît d'une quantité égale (au premier ordre) à celle de tout accroissement de la puissance la raie λi du signal amplifié, car la consommation des porteurs en excès se répartit entre la raie λo et la raie λi. Si la puissance du signal d'entrée augmente, la puissance de l'oscillation décroît éventuellement jusqu'à l'extinction complète de cette raie λo. Au-delà de l'extinction, le gain de l'amplificateur n'est plus constant. Il commence à diminuer, ce qui entraîne une réapparition de la non-linéarité. La puissance du signal amplifié doit donc rester inférieure ou égale à la puissance de la raie d'oscillation émise par les extrémités du guide en l'absence de tout signal d'entrée, pour que l'amplificateur soit maintenu en deçà du seuil de réapparition de la non-linéarité.

Pour obtenir une puissance du signal amplifié qui soit importante, il faut donc que la puissance de la raie d'oscillation soit elle-même importante, en l'absence de signal d'entrée. Il est donc nécessaire d'augmenter le courant électrique injecté, bien au-delà du seuil d'oscillation, typiquement deux à quatre fois l'intensité correspondant à ce seuil.

D'autre part, contrairement au cas d'un laser classique dans lequel il faut minimiser le gain nécessaire pour l'oscillation et donc utiliser une forte contre-réaction optique, il est nécessaire de maximiser le gain nécessaire à l'oscillation, dans l'amplificateur selon l'invention. Pour cela, il faut minimiser le coefficient de couplage entre les moyens résonants et mode guidé par le guide. Un coefficient de réflectivité de ces moyens résonants égal à - 2O dB permet d'obtenir un gain de 20 dB dans l'amplificateur. A titre de comparaison, le gain est de 5 dB dans un laser à semi-conducteur classique.

La figure 2 représente schématiquement un premier exemple de réalisation de l'amplificateur selon l'invention. Il comporte :
- deux électrodes parallèles 1 et 6, permettant d'injecter un courant électrique de pompage I;
- un substrat semiconducteur 8 constitué d'un premier matériau semi-conducteur de type N, compris entre les électrodes 1 et 6;
- une couche de confinement 2, constituée du même premier matériau, mais avec un dopage P+ opposé à celui du substrat 8;
- un guide optique 3, actif sur toute sa longueur, et dont l'axe longitudinal est parallèle aux électrodes 1 et 6; constitué d'un second matériau semiconducteur dont la maille est accordée avec celle du premier matériau et qui a un indice de réfraction plus grand que celui du premier matériau;
- un réseau distribué 4 s'étendant tout le long du guide 3; constitué d'une mince couche de matériau semiconducteur d'indice plus élevé que celui du substrat 8, et gravé périodiquement dans une partie ou dans la totalité de l'épaisseur de cette couche;
- deux faces clivées, 5 et 7, traitées antireflets, terminant le substrat 8, perpendiculairement à l'axe longitudinal du guide 3.

La longueur du guide 3 est inférieure à celle du substrat 8, pour que les deux extrémités du guide 3 constituent deux fenêtres enterrées dans le substrat 8 à une certaine distance des faces 5 et 7 respectivement.

Le guide 3 est réalisé par un procédé classique pour réaliser un amplificateur optique à semi-conducteur. Il est 5 réalisé, par exemple, en InGaAsP pour une utilisation à 1,5 ou 1,3 micron. Le substrat 8 est en InP. Ils peuvent être réalisés par un procédé classique d'épitaxie par jet moléculaire, ou en phase vapeur.

Un signal optique d'entrée noté Pi est appliqué à une extrémité du guide 3 à travers la face 7. Un signal optique amplifié noté Ps émerge de la face 5.

Le pas du réseau 4 est choisi de telle façon que la longueur d'onde de Bragg de ce réseau soit dans la plage spectrale d'amplification du matériau semiconducteur du guide actif 3. Le réseau 4 réfléchit toute onde se propageant dans le guide 3 et ayant cette longueur d'onde de Bragg. La profondeur du réseau 4 et sa distance vis-à-vis du guide 3 déterminent le coefficient de couplage entre le mode guidé par le guide 3 et le réseau 4. Ce coefficient de couplage est choisi de telle façon qu'il y ait oscillation, et que le gain nécessaire à l'oscillation ait une valeur élevée, par exemple 20 dB.

Les faces 5 et 7 sont traitées antireflets pour supprimer les pertes de Fresnel, et l'effet Fabry-Perot naturel dû aux faces clivées 5 et 7 du substrat 2, qui se traduirait par une ondulation indésirable du gain en fonction de la longueur d'onde. En outre, les faces 5 et 7 doivent être traitées anti-reflets pour que l'amplificateur fonctionne en ondes progressives, en dehors de la bande de la raie d'oscillation. Pour obtenir de faibles valeurs de réflectivité des faces 5 et 7, inférieures à 10⁻⁴, il peut être nécessaire de désaligner l'axe longitudinal du guide 3 par rapport à la normale aux faces 5 et 7, ou bien d'interrompre le guide actif 3 avant les faces 5 et 7, pour constituer des fenêtres enterrées. L'exemple de réalisation représenté sur la figure 2 comporte de telles fenêtres enterrées, la longueur du guide 3 étant choisie inférieure à la longueur du substrat 8 pour que les deux extrémités du guide 3 soient enterrées dans le substrat 8 à une certaine distance des faces 5 et 7 respectivement.

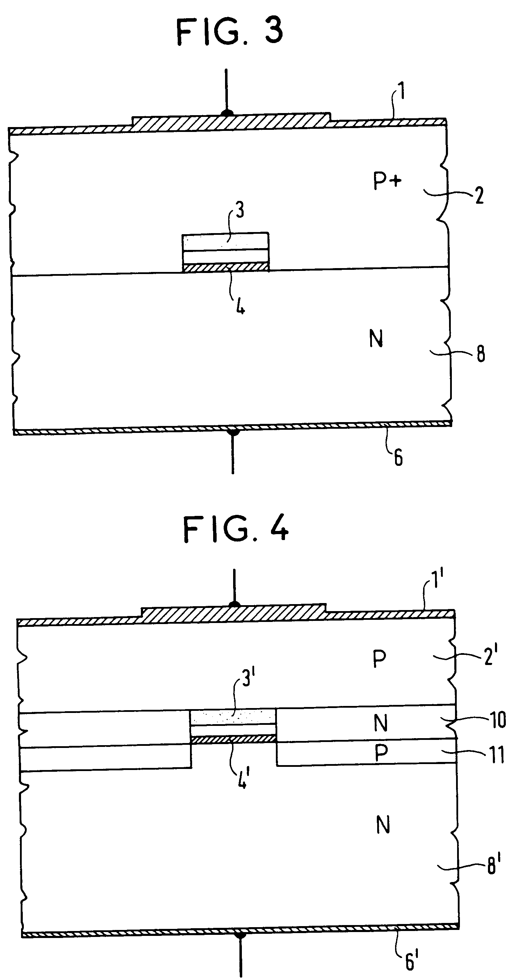

La figure 3 représente une vue en coupe transversale du premier exemple de réalisation. Dans cet exemple, le confinement du courant dans le guide actif 3 est obtenu par une homojonction latérale : la jonction entre la couche de confinement 2, de type P+, et le substrat 8, de type N, présente une tension de seuil supérieure hors de la zone du guide actif 3, ce qui amène le courant électrique à passer préférentiellement à travers le guide actif 3.

La figure 4 représente une vue en coupe transversale d'une variante du premier exemple de réalisation, dans laquelle le confinement est réalisé différemment. Une couche 11 de type P puis une couche 10 de type N sont déposées successivement par dessus la couche du substrat 8', de type N, puis une couche de confinement 2', de type P, est déposée. Ainsi, une jonction polarisée en inverse, constituée par les couches 10 et 11, empêche le passage du courant latéralement. Selon une autre variante de réalisation, les couches 10 et 11 peuvent être remplacées par une seule couche semi-isolante.

Selon une variante de réalisation de ce premier exemple, il peut comporter une transition adiabatique classique, à chaque extrémité du guide 3, pour élargir le mode guidé, aux deux extrémités du guide 3, et ainsi faciliter le couplage du guide 3 avec un guide externe constitué d'une fibre optique à chaque extrémité, d'une part pour amener le signal d'entrée et d'autre part pour recevoir le signal de sortie.

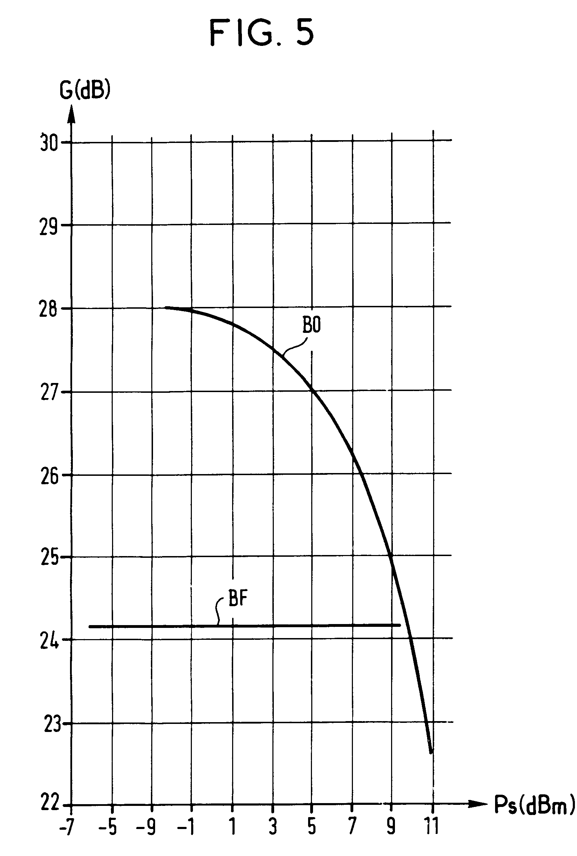

La figure 5 représente le graphe BO du gain d'un amplificateur optique à semiconducteur de type classique, et le graphe BF du gain d'un amplificateur selon l'invention, en fonction de la puissance Ps du signal amplifié fourni par ces amplificateurs. Ces deux amplificateurs sont réalisés avec les mêmes matériaux et les mêmes dimensions. Ils sont alimentés avec la même intensité de courant électrique.

Le graphe BO montre que le gain est de 28 db pour les petits signaux et qu'il décroît avec une pente croissant avec la puissance de sortie, jusqu'à une valeur de gain voisine de 24 dB qui correspond à la puissance maximale, voisine de 9 dBm, que peut fournir cet exemple de réalisation quelle que soit la puissance du signal d'entrée, pour un courant électrique injecté donné. Cette puissance maximale 9 dBm est atteinte pour une compression du gain de l'ordre de 4 dB par rapport au gain pour des petits signaux. Par conséquent, il faut accepter au moins 4 dB de compression de gain pour exploiter toute la puissance disponible à la sortie de cet amplificateur classique, c'est-à-dire accepter un niveau de non-linéarité très élevé.

Le graphe BF est pratiquement une droite d'ordonnée constante, voisine de 24 dB. Cette ordonnée est égale au gain obtenu au voisinage de la puissance maximale 10 dBm que peut fournir l'amplificateur classique. Ces graphes montrent donc que l'amplificateur selon l'invention permet d'exploiter la puissance maximale d'un amplificateur avec un gain maintenu constant quelle que soit la puissance du signal d'entrée.

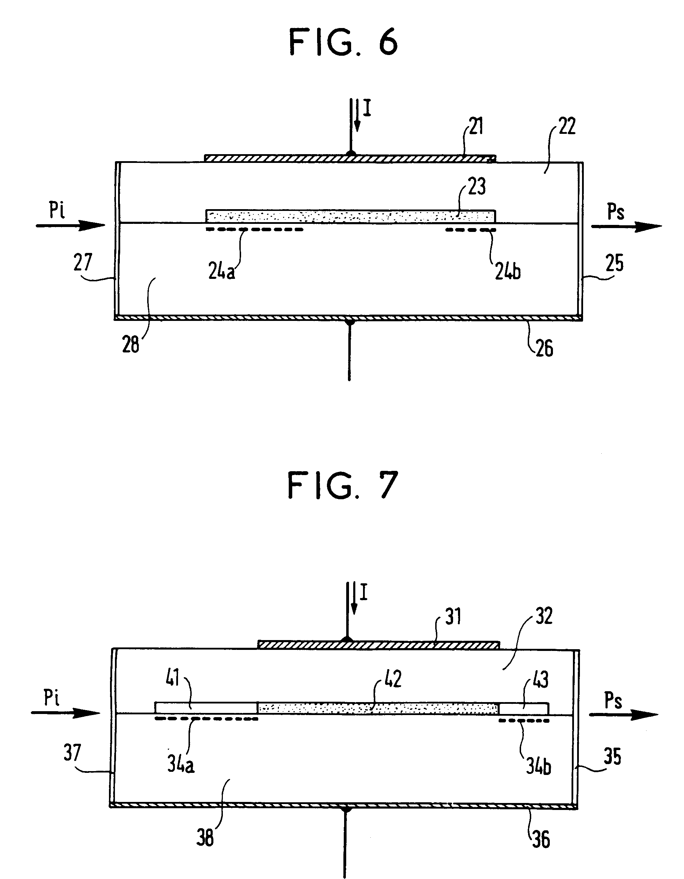

La figure 6 représente un autre exemple de réalisation comportant :
- deux électrodes 21 et 26;
- un substrat 28;
- un guide 23, actif sur toute sa longueur;
- deux réseaux distribués 24a et 24b, parallèles au guide 23, le réseau 24a étant couplé à l'extrémité du guide 23 qui constitue l'entrée de l'amplificateur, et le réseau 24b étant couplé à l'extrémité du guide 23 constituant la sortie de l'amplificateur;
- deux faces clivées 25 et 27 terminant le substrat 28, perpendiculairement à l'axe longitudinal du guide 23.

La longueur du guide 23 est inférieure à celle du substrat 28 de telle sorte que les extrémités du guide 23 constituent des fenêtres enterrées à l'intérieur du substrat 22, à une certaine distance des faces clivées 25 et 27.

Les deux réseaux 24a et 24b n'ont pas le même 5 coefficient de couplage avec le guide 23. Ils sont faits dans une même couche et sont situés à la même distance vis-à-vis du guide 23, mais le réseau 24b a une longueur inférieure à celle du réseau 24a, de façon à présenter un coefficient de couplage inférieur. Les réseaux 24a et 24b ne dépassent pas les extrémités du guide 23. La partie médiane du guide 23 n'est couplée à aucun des deux réseaux. Par rapport au premier exemple de réalisation, cette structure permet de mieux répartir, le long du guide 23, la contre-réaction réalisée par l'oscillation à la longueur d'onde λ_{O} en dissymétrisant le champ de la raie oscillante, et donc la densité de porteurs le long du guide . L'effet de non-linéarité est croissant le long du guide 23, car l'amplitude du signal amplifié est croissante le long du guide 23 et atteint son maximum à proximité de la sortie de l'amplificateur. Pour appliquer une contre-réaction dosée en fonction de l'importance de la non-linéarité à réduire, il est donc souhaitable d'avoir un champ oscillant croissant de l'entrée vers la sortie de l'amplificateur. C'est pourquoi le réseau 24a a un coefficient de couplage plus fort que le réseau 24b.

La figure 7 représente schématiquement un troisième exemple de réalisation de l'amplificateur selon l'invention, comportant :
- deux électrodes 31 et 36;
- un substrat semiconducteur 38, compris entre les électrodes 31 et 36;
- un guide optique comportant une partie active 42 comprise entre deux parties passives 41 et 43, ces parties passives étant constituées d'un matériau dont la bande interdite est plus large que celle du matériau de la partie active 42 pour que ce matériau soit transparent et donc non actif pour l'amplification et l'oscillation;
- deux réseaux distribués 34a et 34b situés respectivement le long de la partie passive 41 et le long de la partie passive 43 du guide;
- deux faces clivées 35 et 37, traitées antireflets, terminant le substrat 38 perpendiculairement à l'axe longitudinale du guide 41, 42, 43.

La longueur totale du guide 41, 42, 43 est inférieure à celle du substrat 38, de telle sorte que les extrémités du guide sont à l'intérieur du substrat et constituent des fenêtres enterrées dans le substrat 32 à une certaine distance des faces clivées 35 et 37. Le réseau 34a s'étend sur toute ou partie de la longueur de la partie passive 41, mais pas au-delà; en particulier, il ne s'étend pas le long de la partie active 42. De même, le réseau 34b s'étend sur toute ou partie de la longueur de la partie passive 43, mais il ne s'étend pas le long de la partie active 42. Ce mode de réalisation présente l'avantage d'obtenir un champ électromagnétique plus uniforme dans les extrémités de la partie active 42, car les irrégularités de champ engendrées par les réseaux 34a et 34b restent localisées à leur voisinage immédiat, c'est-à-dire dans les parties passives 41 et 43 du guide. Le fait que le champ engendré par les réseaux 34a et 34b dans la partie active 42 soit plus uniforme permet de mieux maîtriser la contre réaction appliquée à l'amplification et donc d'améliorer la constance du gain de l'amplificateur.

La portée de l'invention n'est pas limitée aux exemples décrits ci-dessus, il est à la portée de l'Homme de l'art de réaliser autrement les moyens résonants qui sont couplés au guide actif, en respectant deux conditions :
- le coefficient de couplage doit être relativement faible pour que l'amplificateur ait un gain intéressant;
- la réponse des moyens résonants doit être rapide, vis-à-vis du rythme de modulation du signal à amplifier, pour que la contre-réaction suive le rythme des variations de gain engendrées par la modulation.

Dans certaines applications, la raie d'oscillation peut être utilisée pour détecter ou surveiller le signal amplifié. Son amplitude varie en opposition de phase avec celle du signal amplifié.

## Revendications

**1)** Amplificateur optique à semiconducteur, présentant une non-linéarité réduite, caractérisé en ce qu'il comporte un guide optique (3; 23; 41, 42, 43) et des moyens résonants (4; 24a, 24b; 34a, 34b) couplés à ce guide pour faire osciller cet amplificateur à une longueur d'onde (λO) unique et différente de la longueur d'onde d'un signal à amplifier (λᵢ), mais appartenant à la bande de gain de l'amplificateur, et pour assurer une amplification à onde progressive, du signal à amplifier.

**2)** Amplificateur selon la revendication 1, caractérisé en ce que les moyens résonants comportent au moins un réseau distribué (4; 24a, 24b; 34a, 34b), chaque réseau étant couplé au guide optique (3) et ayant une longueur d'onde de Bragg égale à la longueur d'onde choisie pour l'oscillation.

**3)** Amplificateur selon la revendication 2, caractérisé en ce que les moyens résonants comportent un premier et un second réseau distribué (24a, 24b; 34a, 34b) couplés respectivement à une première et à une seconde extrémité du guide (3; 23; 41, 42, 43).

**4)** Amplificateur selon la revendication 3, caractérisé en ce que le guide comporte une partie active (42) et deux parties passives (41, 43) prolongeant respectivement les deux extrémités de la partie active (42); et en ce que les deux réseaux (34a, 34b) sont couplés respectivement aux deux parties passives (41, 43) et non à la partie active (42) du guide.

**5)** Amplificateur selon la revendication 3, caractérisé en ce que les deux réseaux (34a, 34b) n'ont pas le même coefficient de couplage avec le guide; celui (346) couplé à l'extrémité (33) constituant la sortie de l'amplificateur ayant un coefficient de couplage plus élevé que celui(34a) couplé à l'extrémité (31) constituant l'entrée de l'amplificateur.

**6)** Amplificateur selon la revendication 1, caractérisé en ce qu'il comporte un substrat (8) terminé par des faces clivées (7, 5) traitées anti-reflets.
